# EUROPEAN PATENT APPLICATION

(11) **EP 1 688 991 A2**
(43) Date of publication of application: **09.08.2006**
(21) Application number: 06002047.6
(22) Date of filing: 01.02.2006
(51) Int. Cl.: H01L 21/762

(54) **Soi wafer production method**

(30) Priority: 04.02.2005 JP 2005028825
(71) Applicant: SUMCO Corporation, Tokyo 105-8634 (JP)
(72) Inventor: Murakami, Satoshi, Tokyo 105-8634 (JP); Ono, Toshiaki, Tokyo 105-8634 (JP); Endo, Akihito, Tokyo 105-8634 (JP)
(74) Representative: Albrecht, Thomas

(57) **Abstract**

By using, in the so-called Smart Cut process comprising the steps of bonding an ion-implanted active layer wafer to a base wafer and later splitting off the base wafer to produce a SOI wafer, a wafer doped with C in a single crystal ingot growing process (desirably to a carbon concentration of not lower than 1 x 10¹⁶ atoms/cm³) as the active layer wafer, it becomes possible to exhibit the effect of inhibiting agglomeration of interstitial Si atoms and prevent development of stacking faults even when the SOI wafer is subjected to thermal oxidation treatment. Furthermore, the technique of sacrificial oxidation can be applied to production of SOI wafers and, thus, a damaged layer formed on the SOI layer surface can be removed and surface roughness can be improved without impairing crystalline integrity and, further, SOI layer thickness can be efficiently reduced.

## Description

### FIELD OF THE INVENTION

This invention relates to the so-called Smart Cut (registered trademark) process for producing SOI (silicon on insulator) wafers by bonding an ion-implanted active layer wafer to a base wafer, followed by splitting and, more particularly, to a method of producing SOI wafers by which a damaged layer present on the SOI layer surface after splitting can be removed and surface roughness can be improved and at the same time development of stacking faults caused by the damaged layer can be prevented.

### DESCRIPTION OF THE PRIOR ART

Recently, particular attention has been given to SOI wafers having a SOI structure with a silicon layer (SOI layer) formed on an insulator as high-performance wafers for manufacturing LSIs to be used in electronic devices, since the devices derived therefrom are excellent in high-speed performance, low electric power consumption, high resistance to voltage and environmental resistance, among others.

Available as a typical method of producing such SOI wafers is a wafer bonding method in addition to the SIMOX (separation by implanted oxygen) technology featured by implanting high concentration oxygen ions into silicon wafers, followed by high temperature heat treatment for oxide film formation within the wafers. This wafer bonding method is a technology of producing SOI wafers having a SOI layer formed on a buried insulator oxide film by forming an oxide film on an active layer wafer which is to form a SOI layer and bonding the wafer to a base wafer via the oxide film and then reducing the thickness of the active layer wafer.

As a process for producing SOI wafers which utilizes the principle of this wafer bonding method, there is the Smart Cut process proposed in Japanese Patent Publications No. 5-211128 and No. 10-50628. According to this Smart Cut process, an oxide film is formed on the active layer wafer, hydrogen ions or rare-gas ions are implanted in the wafer from its upper side via the oxide film to form an ion-implanted layer (microcellular layer) within the active layer wafer, the wafer is closely bonded to a base wafer via the oxide film, the whole is then heat-treated for splitting, and the activated wafer layer is split off in a thin layer form with the implanted layer as the boundary, further followed by heat treatment for bond strengthening to give a SOI wafer.

However, when SOI wafers are produced by this Smart Cut process, an ion implantation-due damaged layer is formed on the SOI layer surface after splitting and, further, the surface roughness is significantly deteriorated and the surface condition is inferior. After splitting by heat treatment, there remains a damaged layer with a thickness of 700 -1000 Å formed, and a number of crystal defects due to this damaged layer are present. In a device manufacturing process using such wafers, these crystal defects cause deteriorations in the characteristics of the devices formed on the SOI layer.

Therefore, in the Smart Cut process, chemical mechanical polishing (CMP) is carried out in a final step after the heat treatment for bond strengthening for removing such a damaged layer. In recent years, however, requirements with respect to uniformity in in-plane film thickness have become severer with the trend for the SOI layer thickness to become thinner. When mirror polishing involving an element such a machining process is carried out in the final step in producing SOI wafers, the uniformity in SOI layer thickness as attained by the ion implantation and the splitting becomes worsened since the margin for polishing and etching cannot be controlled to a satisfactory extent.

Therefore, a method involving a so-called sacrificial oxidation has been proposed. According to this method, the SOI wafer after splitting is subjected to heat treatment in an oxidizing atmosphere for the formation of an oxide film on the SOI layer and then the damaged layer is removed and absorbed in the oxide film. For example, in the method of producing SOI wafers as proposed in Japanese Patent Publication No. 2000-124092, there is disclosed a technology featured by subjecting a wafer surface after splitting to oxidation treatment for the formation of an oxide film thereon, then removing the oxide film using a hydrofluoric acid (HF)-containing solution and subsequently subjecting the wafer to heat treatment in a hydrogen-containing reducing atmosphere to thereby smoothen the surface. According to the treatment method proposed by the sacrificial oxidation, the damaged layer can be removed with good controllability without depending on polishing, which is a machining process, and, at the same time, the SOI layer thickness can be reduced.

### SUMMAEY OF THE INVENTION

By removing the damaged layer formed on the SOI layer surface and making the SOI layer thinner by the sacrificial oxidation method featured by forming an oxide film in the SOI layer and later removing that oxide film, as mentioned above, it is possible to remove the damaged layer on the SOI layer surface without deteriorating the uniformity in SOI layer thickness and, further, facilitate the reduction in SOI layer thickness to a predetermined level.

More specifically, as regards the uniformity in SOI layer thickness, the uniformity attainable by the polishing technique such as CMP is plus/minus several hundreds of Å, whereas such uniformity as plus/minus several tens of Å can be satisfactorily attained by the sacrificial oxidation-based treatment, with good controllability. Thus, the sacrificial oxidation is effective as a treatment method for removing the damaged layer formed on the SOI layer surface, without deteriorating the uniformity in SOI layer thickness.

However, when a SOI wafer is subjected to heat treatment in an oxidizing atmosphere, stacking faults develop due to the damaged layer on the SOI layer surface. When the sacrificial oxidation was carried out, for example, by heating at 1050°C in an oxidizing atmosphere, and the wafer surface after removal of the damaged layer was observed under a Transmission Electron Microscopy (TEM), the presence of about 1 x 10⁹ stacking faults/cm² was confirmed.

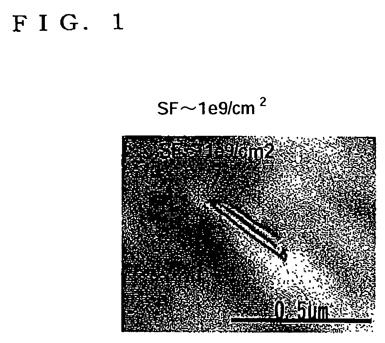

Fig. 1 shows stacking faults observed, by Transmission Electron Microscopy (TEM), in the SOI layer after sacrificial oxidation treatment. These stacking faults consist of an agglomerate of interstitial silicon atoms. Thus, the oxidative heat treatment of a SOI wafer is accompanied by aggregation of interstitial silicon atoms released into the SOI layer at the damaged layer (in particular in the neighborhood of an interface between the damaged layer and damage-free SOI layer) serving as an initiation point, resulting in the formation of stacking faults by the interstitial silicon atoms that have agglomerated.

The occurrence of stacking faults in the SOI layer not only leads to impairment in crystalline integrity of the SOI layer but also causes deterioration in surface roughness. There is a further problem that when the oxide film is removed by using an HF solution, the HF solution penetrates into a buried oxide film and partially etches the buried oxide film being present just below, causing formation of micro defects. An object of the present invention, which has been made in view of the problems discussed above, is to provide a method of producing SOI wafers by which the damaged layer formed on the SOI layer surface can be removed without deteriorating the uniformity in SOI layer thickness even by the sacrificial oxidation treatment in the Smart Cut process and the surface roughness can be improved without impairing the crystalline integrity and, at the same time, the SOI layer thickness can be efficiently reduced to a predetermined level.

The present inventors made various investigations in an attempt to accomplish the above object, paying attention to the fact that when a silicon single crystal is doped with carbon (C), dopant C atoms are present at interstitial sites and bond to interstitial silicon (Si) atoms and effectively inhibit the agglomeration of interstitial Si atoms. They revealed that this effect of inhibiting the agglomeration of interstitial Si atoms becomes significant at and above a C concentration of 1 x 10¹⁶ atoms/cm³ (ASTM F 123-1981) and that effect of inhibiting the agglomeration of interstitial Si atoms becomes more significant as the C concentration increases.

The method of producing SOI wafers according to the present invention which produces SOI wafers with a SOI layer formed on a buried oxide film by forming an ion-implanted layer by implanting hydrogen ions or rare-gas ions in an active layer wafer via an insulator film, then bonding the active layer wafer to a base wafer via the insulator film, subjecting the resulting bonded wafer assembly to heat treatment and splitting off the ion-implanted layer is characterized in that a wafer doped with C in a process of single crystal ingot growing is used as the active layer wafer.

Thus, by applying the effect of inhibiting the agglomeration of interstitial Si atoms attainable by doping a silicon single crystal with C to the Smart Cut process, it becomes possible to prevent the agglomeration of interstitial Si atoms released into the SOI layer even when the SOI wafer is subjected to heat treatment in an oxidizing atmosphere and thus prevent the development of stacking faults.

In this way, by forming an oxide film in the SOI layer and carrying out the sacrificial oxidation for removing the oxide film, it is possible to remove the damaged layer formed on the SOI layer surface without deteriorating the uniformity in SOI layer thickness, and improve the surface roughness without impairing the crystalline integrity and, further, efficiently reduce the SOI layer thickness.

In carrying out the method of producing SOI wafers according to the present invention, it is desirable that a carbon concentration in the active layer wafer be not lower than 1 x 10¹⁶ atoms/cm³ (ASTM F 123-1981). The effect of inhibiting the agglomeration of interstitial Si atoms is then exhibited significantly.

Further, according to the method of producing SOI wafers in accordance with the present invention, the damaged layer present on the SOI layer surface is removed after heat treatment to the bonded wafer assembly and splitting of the ion-implanted layer, so that it is possible to form an oxide film on the SOI layer surface by heat treatment in an oxidizing atmosphere and then remove that oxide film using the HF solution.

Even when the oxide film is removed using the HF solution, there remain no crystal defect-due pits on the SOI layer surface and there occurs no penetration of the HF solution into the buried oxide film and, therefore, no microdefects are formed in the SOI wafer.

Further, according to the method of producing SOI wafers in accordance with the present invention, the characteristic requirement that the density of stacking faults as observed, under a Transmission Electron Microscopy (TEM), of the SOI layer surface after removal of the oxide film formed on that surface should be not higher than 1 x 10⁴/cm² can be satisfied.

By using, according to the method of producing SOI wafers in accordance with the present invention, a wafer doped with C in the single crystal ingot growing process as the active layer wafer, the effect of inhibiting the agglomeration of interstitial Si atoms can be exhibited and, even when the SOI wafer is subjected to heat treatment in an oxidizing atmosphere (thermal oxidation treatment), the agglomeration of interstitial Si atoms released into the SOI layer can be inhibited, so that the development of stacking faults can be prevented.

In this way, the sacrificial oxidation can be applied to the production of SOI wafers by the Smart Cut process, the damaged layer formed on the SOI layer surface can be removed without deteriorating the uniformity in SOI layer thickness, the surface roughness can be improved without impairing the crystalline integrity, and the SOI layer thickness can be efficiently reduced to a predetermined level.

Furthermore, even when the oxide film is removed using the HF solution, there are no crystal defect-due pits present on the SOI layer surface and no penetration of the HF solution into the buried oxide film occurs and, therefore, no micro defects are developed in the SOI wafer.

### BRIEF DESCRIPTION OF THE DRAWINGS

Fig. 1 shows a stacking fault in the SOI layer after sacrificial oxidation treatment as observed using a Transmission Electron Microscopy (TEM).
Fig. 2 shows a process flowchart schematically illustrating a method of producing SOI wafers by the Smart Cut process in accordance with the present invention.

### DETAILED DESCRIPTION OF THE INVENTION

According to a SOI wafer production method of the present invention, a wafer doped with C in a single crystal ingot growing process is used as a SOI layer-constituting active layer wafer. Owing to the effect of doping with C, the development of stacking faults otherwise induced in the SOI layer is inhibited even on the occasion of thermal oxidation treatment, with the result that occurrence of crystal defects is reduced and crystalline integrity is guaranteed.

A concentration of C contained in the active layer wafer is desirably not lower than 1 x 10¹⁶ atoms/cm³ (ASTM F 123-1981), since the effect of inhibiting agglomeration of interstitial Si atoms can be significantly exhibited then.

According to the SOI wafer production method of the present invention, the effect of inhibiting the agglomeration of interstitial Si atoms becomes more significant as the C concentration increases. Therefore, any particular upper limit thereto is defined. Naturally, however, the upper limit is ruled by the solubility limit of C in Si, namely 4-5 x 10¹⁷ atoms/cm³.

On the other hand, when a silicon single crystal is grown by the Czochralski process in an environment close to the solubility limit of C, slight changes in pulling up conditions may readily cause introduction of crystal defects. Therefore, in carrying out the SOI wafer production method of the present invention, it is desirable that the C concentration be 1 x 10¹⁶ to 1 x 10¹⁷ atoms/cm³. Furthermore, it is more desirable that the C concentration be 5 x 10¹⁶ to 1 x 10¹⁷ atoms/cm³ so that the sacrificial oxidation may be carried out at a higher temperature (exceeding 1050°C), at which stacking faults are readily formed in the SOI layer, at an increased throughput level.

In carrying out the SOI wafer production method of the present invention, in addition to the above-specified C concentration, the initial interstitial oxygen concentration in the active layer wafer may be 8 x 10¹⁷ to 14 x 10¹⁷ atoms/cm³ (ASTM F121-1979). It is intended that soluble oxygen which general-purpose silicon single crystals grown by the conventional Czochralski process should contain be included therein. Even in this case, when the oxygen concentration is excessively high, oxide precipitates may be formed in the SOI layer depending on heat treatment conditions and, therefore, the oxygen concentration is desirably 8 x 10¹⁷ to 11 × 10¹⁷ atoms/cm³.

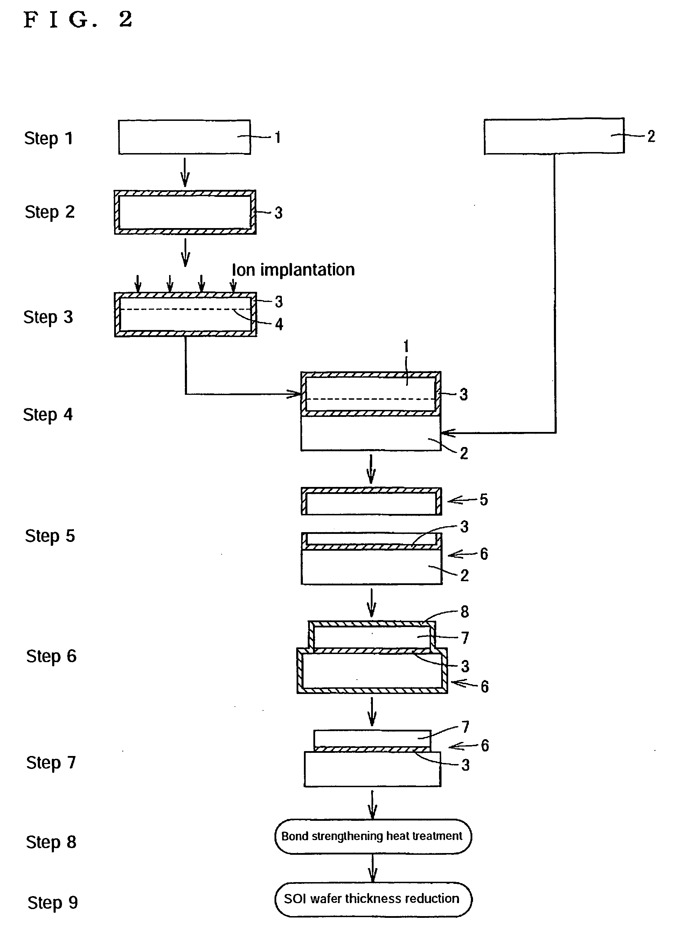

Fig. 2 shows a process flowchart schematically illustrating a method of producing SOI wafers by the Smart Cut process in accordance with the present invention. In the following, the steps 1 to 9 in an embodiment of the SOI wafer production method of the present invention as shown in Fig. 2 are described step by step.

In Step 1, a C-doped active layer wafer 1 and a base wafer 2 are prepared, and at least surfaces to be bonded together are subjected to mirror polishing.

In Step 2, an oxide film 3 is formed on the surface of the active layer wafer 1. This oxide film 3 is to become a buried oxide film 3 in the SOI wafer and the thickness thereof is set according to the use and customer's demand. The formation of the oxide film 3 is carried out by inserting a silicon wafer in an oxidation furnace and heating the same at a predetermined temperature for a predetermined period of time.

The C-doped active layer wafer has a precipitation-promoting effect and, for that effect to be exhibited, 2-step treatment including lower temperature treatment (600-800°C) and higher temperature treatment (900-1100°C) is required. In case of SOI wafers, however, it is desired that the precipitation be avoided; therefore, the oxidation treatment temperature in the later heat treatment step herein is desirably carried out at a high temperature of 900-1100°C so that the precipitation of oxide precipitates in the SOI layer may be avoided.

In Step 3, the active layer wafer 1 with the oxide film formed thereon is set in a vacuum chamber of an ion implantation apparatus, and hydrogen ions or rare-gas ions are implanted in the active layer wafer 1 from the surface thereof through the oxide film 3 at a selected acceleration voltage and dose window. The hydrogen ions or rare-gas ions are implanted into the active wafer layer 1 to a site at a predetermined depth from the surface thereof, and an ion-implanted layer 4 is formed in the active layer wafer 1 at the predetermined depth therein. On that occasion, it is necessary to select the dose window enabling hydrogen splitting. Desirably, a lower limit is set at 4 x 10¹⁶ atoms/cm², and an upper limit is set at 1 x 10¹⁷ atoms/cm² from the throughput viewpoint.

In Step 4, the active layer wafer 1 after hydrogen ion or rare-gas ion implantation is bonded, with the ion-implanted surface (the surface of the oxide film 3) as a bonding surface, to the base wafer 2, to obtain a bonded wafer assembly with the insulator film 3 (oxide film) intervening between the bonded surfaces.

Prior to bonding, Standard Cleaning 1 using a mixed solution comprising ammonium hydroxide and aqueous hydrogen peroxide or/and Standard Cleaning 2 using a mixed solution comprising hydrogen chloride and aqueous hydrogen peroxide are performed, either alone or in combination for removal of surface impurities.

In Step 5, the bonded wafer assembly is heat-treated in an inert gas atmosphere for formation of hydrogen gas bubbles in the ion-implanted layer, and a part of the active layer wafer 1 is split off with the ion-implanted layer as a boundary. The bonded wafer assembly is thus separated into a split-off wafer 5 and a SOI wafer 6. In case of hydrogen implantation, a temperature for splitting off the active layer wafer 1 is required to be not lower than 400°C so that hydrogen gas bubbles may be formed. From the throughput viewpoint, however, the temperature is desirably not higher than 700°C, although splitting can be attained at a higher temperature as well.

In Step 6, an oxide film 8 is formed by thermal oxidation treatment so that the damaged layer present on the surface of the SOI layer 7 may be removed and the surface roughness may be improved. The damaged layer has a thickness of 700-1000 Å, and it is necessary to oxidize the Si layer to a depth at least corresponding to that thickness. Therefore, the thickness of the oxide film 8 is required to be twice that thickness, namely 1500-2000 Å. Since a rate of oxidation becomes high as a thermal oxidation temperature rises, a high temperature is desirable but, as the oxidation temperature rises, stacking faults develop more easily.

Therefore, from the viewpoint of quality characteristics of the SOI layer 7 and the throughput, the oxidation temperature is desirably 800°C to 1100°C, more desirably 850°C to 1000°C. In case of a wafer not doped with C, stacking faults are readily induced and, therefore, the oxidation temperature is required to be not higher than 900°C.

Further, for increasing the rate of oxidation even when the oxidation temperature is low, the technique of pyrogenic oxidation featured by carrying out the oxidation in H₂O atmosphere prepared by reacting oxygen (O₂) gas with hydrogen (H₂) gas, or the technique of HCI oxidation featured by carrying out the oxidation with mixed gas composed of oxygen (O₂) and HCl, for instance, may also be applied.

In Step 7, the oxide film 8 formed on the SOI layer 7 is removed. The removal of this oxide film 8 is carried out by etching with an HF-containing solution, for instance. Etching with the HF-containing solution results in the removal of the oxide film alone by etching, whereby a SOI wafer 6 from which the damaged layer is removed can be obtained.

In Step 8, high-temperature heat treatment is carried out in the manner of bond strengthening heat treatment to sufficiently secure bond strength. For attaining a sufficient level of bond strength, a treatment temperature is required to be not lower than 1100°C. Since, however, slips may readily occur at a high temperature, an upper limit is set at 1200°C. In a preferred example, the treatment is carried out at a temperature not lower than 1100°C for a period of not shorter than 1 hour. As the atmosphere, such a non-oxidizing atmosphere as N₂, Ar or H₂ can be employed.

When, on the other hand, the dopant C remains in the SOI layer of SOI products at a high concentration, there is the possibility of deteriorating device characteristics. Since, however, C in a high-temperature condition readily diffuses outwardly, the concentration of C contained in the SOI layer can be reduced to 5 x 10¹⁵ atoms/cm³ and the fear of the device characteristics being deteriorated can be dissipated by carrying out the above-mentioned heat treatment at 1100°C or above.

The treatment in Ar or H₂ atmosphere at a high temperature not lower than 1100°C is effective in smoothening the SOI layer surface, hence in improving the surface roughness.

Step 9 is a step of reducing the thickness of the SOI wafer. After bond strengthening heat treatment, the product SOI wafer is produced by reducing the layer thickness to a predetermined level by applying, for example, the sacrificial oxidation where necessary. In the following, the effects of the SOI wafer production method of the present invention are explained based on specific examples with the production of test wafers of Inventive Examples, Comparative Example 1 and Comparative Example 2.

### EXAMPLES

In Inventive Examples, wafers, 200 mm in diameter, were cut out of respective silicon single crystal ingots produced by doping with C by the Czochralski process, showing p type conductivity and having a resistivity of 1-20 Ω cm, and then mirror-polished. Each C-doped single crystal was produced by pulling up a single crystal from a silicon melt doped with a predetermined amount of a C powder.

The wafers thus obtained respectively had three levels of C concentration, namely 1 x 10¹⁶ atoms/cm³, 5 x 10¹⁶ atoms/cm³ and 1 x 10¹⁷ atoms/cm³, and had an oxygen concentration of 8 x 10¹⁷ atoms/cm³ to 14 x 10¹⁷ atoms/cm³. These were divided into active layer wafers and base wafers. The C concentration was confirmed by infrared absorption spectrometry (IR absorption).

In Comparative Example 1, mirror surface silicon wafers, 200 mm in diameter, produced without C doping, showing p type conductivity and having a resistivity of 1-20 Ω cm were used, and wafers having an oxygen concentration of 8 x 10¹⁷ atoms/cm³ to 14 x 10¹⁷ atoms/cm³ were prepared and these were divided into active layer wafers and base wafers.

In Comparative Example 2, mirror surface silicon wafers, 300 mm in diameter, produced with C doping in the same manner as in Inventive Examples, showing p type conductivity and having a resistivity of 1-20 Ω cm were used, and wafers having an oxygen concentration of 8 x 10¹⁷ atoms/cm³ to 14 x 10¹⁷ atoms/cm³ were prepared and these were divided into active layer wafers and base wafers.

Using the active layer wafers and base wafers prepared, SOI wafers were produced by the Smart Cut process via the above-mentioned steps as shown in Fig. 3. First, as described above referring to Step 2, oxide film formation on an active layer wafer surface was carried out by inserting silicon wafers into an oxidizing furnace and subjecting them to thermal oxidation treatment in a dry oxygen atmosphere under the conditions of 1000°C x 4 hours so that thickness of the oxide film formed amounts to 1500 Å.

Then, as described above referring to Step 3, the active layer wafers with the oxide film formed thereon were set in a vacuum chamber of an ion implantation apparatus, and an ion-implanted layer was formed in each active layer wafer by implanting hydrogen ions (H⁺ ions) into the wafer from the surface thereof via the oxide film at an acceleration voltage of 50 keV and a dose window of 6 x 10¹⁶ atoms/cm². Then, the wafers were subjected to 4-minute Standard Cleaning 1 (29% aqueous solution of NH₄OH:30% H₂O₂:pure water = 1:1:8, liquid temperature 80°C) and further to 4-minute Standard Cleaning 2 (36% aqueous solution of HCl:30% H₂O₂:pure water = 1:1:6, liquid temperature 80°C), and each active layer wafer and each base wafer were bonded together.

As described above referring to Step 5, each bonded wafer assembly was subjected to 30-minute heat treatment at 500°C in a nitrogen gas atmosphere, and part (top portion) of the active layer wafer was split off. Then, as described above referring to Step 6, an oxide film with a thickness of 1500 Å was formed by heating in a dry oxygen atmosphere under the conditions of 1000°C x 4 hours for removal of the damaged layer present on the SOI layer surface. In Comparative Example 1, where no C doping was made and therefore there was a tendency for stacking faults to develop with ease, an oxide film with a thickness of 1500 Å was formed under the heating temperature condition of 900°C.

As described above referring to Step 7, each SOI wafer having an oxide film on the SOI layer surface was immersed in HF solution with HF concentration of 50% for 5 minutes to thereby completely remove the surface oxide film together with the damaged layer present on the SOI layer surface. On that occasion, the wafer was immediately washed with water and dried to avoid occurrence of new pitting or the like as a result of etching.

After removal of the damaged layer in the above Step 7, defect density of each SOI layer was measured using a TEM. The results are shown in Table 1.

**Table 1**

| Test No. | Example | C concentration in wafer (atoms/cm³) | Defect density in SOI layer (1/cm²) |
|---|---|---|---|
| 1 | Inventive Example 1 | 1 x 10¹⁶ | 1 x 10⁴ |
| 2 | Inventive Example 2 | 5 x 10¹⁶ | 5 x 10³ |
| 3 | Inventive Example 3 | 1 x 10¹⁷ | 5 x 10³ |
| 4 | Comparative Example 1 | - | 1 x 10⁹ |
| 5 | Comparative Example 2 | 5 x 10¹⁵ | 1 x 10⁹ |

The results shown in Table 1 indicate that the defect density measured in the SOI layers of Comparative Examples 1 and 2 was 1 x 10⁹/cm², whereas all the defect densities in Inventive Examples where doping was made at a C concentration of not lower than 1 x 10¹⁶ atoms/cm³ were good with not higher than 1 x 10⁴/cm², suggesting high quality characteristics. In particular when the C concentration was 5 x 10¹⁶ atoms/cm³ or above, the defect density was of the order of 1 x 10³/cm², and the excellent effect was thus confirmed. Furthermore, in Inventive Examples, it was also confirmed that the uniformity in SOI layer thickness was good and the surface roughness could be improved.

As described hereinabove, by using wafers doped with C in the single crystal ingot growing process as the active layer wafers according to the SOI wafer production method of the present invention, it is possible to exhibit the effect of inhibiting the agglomeration of interstitial Si atoms and prevent the agglomeration of interstitial Si atoms released into the SOI layer even when the SOI wafers are subjected to thermal oxidation treatment, and the development of stacking faults can be prevented accordingly.

Furthermore, the technique of the sacrificial oxidation can be applied to the production of SOI wafers and, therefore, the damaged layer formed on the SOI layer surface can be removed without deteriorating the uniformity in SOI layer thickness and the surface roughness can be improved without impairing the crystalline integrity and, at the same time, the SOI layer thickness can be efficiently reduced to a predetermined level. In addition, even when the oxide film is removed using the HF solution, crystal defect-due pits will not be present on the SOI layer surface and the HF solution will not penetrate into the buried oxide film, either. Thus, micro defects will not be generated in the SOI wafers.

## Claims

1. A method of producing SOI wafers with a SOI layer formed on a buried oxide film by forming an ion-implanted layer by implanting hydrogen ions or rare-gas ions in an active layer wafer via an insulator film, then bonding said active layer wafer to a base wafer via the insulator film, subjecting the resulting bonded wafer assembly to heat treatment and splitting off the ion-implanted layer, **characterized in that** a wafer doped with carbon (C) in a single crystal ingot growing process is used as said active layer wafer.

2. A method of producing SOI wafers according to claim 1, **characterized in that** said active layer wafer has a carbon concentration of not lower than 1 x 10¹⁶ atoms/cm³ (ASTM F 123-1981).

3. A method of producing SOI wafers according to claim 1 or 2, **characterized in that** an oxide film is formed on a SOI layer surface by heat treatment in an oxidizing atmosphere for removing a damaged layer present on said SOI layer surface after subjecting said bonded wafer assembly to heat treatment and splitting off the ion-implanted layer and then the oxide film is removed using a hydrofluoric acid (HF) solution.

4. A method of producing SOI wafers according to claim 3, **characterized in that** density of stacking faults due to said damaged layer as observed using a Transmission Electron Microscopy (TEM) after removal of the oxide film formed on said SOI layer surface is not higher than 1 x 10⁴/cm².
